# EUROPEAN PATENT APPLICATION

(11) **EP 4 456 153 A1**
(43) Date of publication of application: **30.10.2024**
(21) Application number: 24164610.8
(22) Date of filing: 19.03.2024
(51) Int. Cl.: H01L 31/048, H02S 20/22, H02S 20/30, H02S 30/20

(54) **FLEXIBLE PHOTOVOLTAIC MODULE, PHOTOVOLTAIC AWNING AND RECREATIONAL VEHICLE**

(30) Priority: 23.04.2023 CN 202310437282
(71) Applicant: Renogy Suzhou Co., Ltd., Suzhou New District 215011 (CN)
(72) Inventor: HUANG, Jiang, Suzhou New District, 215011 (CN); XIONG, Caicai, Suzhou New District, 215011 (CN); MIKE, Ma, Suzhou New District, 215011 (CN)
(74) Representative: Zacco Sweden AB

(57) **Abstract**

A flexible photovoltaic module includes a front sheet, multiple solar cells and a back sheet which are laminated, the multiple solar cells are located between the front sheet and the back sheet. The front sheet includes a polymer film, a first polyethylene terephthalate film layer and a first bonding layer which are laminated; the first bonding layer is disposed on a first surface of the multiple solar cells. The back sheet includes a second bonding layer and a second PET film layer which are laminated; the second bonding layer is disposed between a second surface of the multiple solar cells and the second PET film layer. The sum thickness of the first PET film layer and the second PET film layer is less than or equal to 150 microns; the sum thickness of the first bonding layer and the second bonding layer is less than or equal to 200 microns.

## Description

### TECHNICAL FIELD

The present application relates to the technical field of photovoltaic modules, for example, a flexible photovoltaic module, a photovoltaic awning and a recreational vehicle.

### BACKGROUND

With the rapid development of renewable energy, solar photovoltaic modules have been widely used. Most photovoltaic modules are glass-based rigid solar panels, such as bifacial glass crystal silicon solar cells. Although there are also flexible or bendable solar cell modules (such as thin-film solar cell modules), photovoltaic modules developed based on these solar cell modules are still not flexible enough for many application scenarios. The main reason is that most photovoltaic modules are designed for application scenarios with relatively high system voltage (such as 600V, 1000V or even 1500V), and therefore a large number of polymer films and adhesive layers are used to meet the mechanical and electrical insulation requirements of these products.

However, for the photovoltaic power generation system with the system voltage less than or equal to 300V, the requirements for electrical insulation are greatly reduced, while for some specific application scenarios, the requirements for flexibility and bendability are greatly improved. For example, when flexible photovoltaic modules are applied to products (such as awnings or canopies of recreational vehicles) which are required to be rolled up/bent with a small radius of curvature, the existing photovoltaic modules still cannot satisfy the requirements of such application scenarios due to their large rigidity. In addition, when the solar awning are rolled up and retracted, the solar cells on the awning cannot generate electricity normally due to being rolled up inside.

### SUMMARY

The present application provides a flexible photovoltaic module, a photovoltaic awning and a recreational vehicle to solve the problem that the flexibility of photovoltaic modules cannot satisfy special application scenarios and the problem related to power generation of solar cells.

In a first aspect, an embodiment of the present application provides a flexible photovoltaic module applied to a photovoltaic power generation system with a system voltage less than or equal to 300V The flexible photovoltaic module includes a front sheet, multiple solar cells and a back sheet which are laminated, where the multiple solar cells are located between the front sheet and the back sheet. The front sheet includes a polymer film, a first polyethylene terephthalate (PET) film layer and a first bonding layer which are laminated; the first bonding layer is disposed on a first surface of the multiple solar cells, and the first PET film layer is bonded to the multiple solar cells through the first bonding layer. The back sheet includes a second bonding layer and a second PET film layer which are laminated; the second bonding layer is disposed between a second surface of the multiple solar cells and the second PET film layer, and the second bonding layer is configured to bond and fix the second PET film layer to the multiple solar cells. The sum of the thickness of the first PET film layer and the thickness of the second PET film layer is less than or equal to 150 microns; the sum of the thickness of the first bonding layer and the thickness of the second bonding layer is less than or equal to 200 microns.

In a second aspect, an embodiment of the present application provides a photovoltaic awning. The photovoltaic awning includes a reel, a flexible photovoltaic module and a bracket. At least part of the flexible photovoltaic module is rolled up on a surface of the reel. The bracket includes at least a fixing bracket and a retractable bracket, the fixing bracket is configured to fix the photovoltaic awning on a mounting surface, and the retractable bracket is configured to drive the reel to move back and forth to make the flexible photovoltaic module in an extended state or a retracted state. The flexible photovoltaic module includes a front sheet, multiple solar cells and a back sheet which are laminated, and the multiple solar cells are located between the front sheet and the back sheet. The front sheet includes a polymer film, a first polyethylene terephthalate (PET) film layer and a first bonding layer which are laminated; the first bonding layer is disposed on a first surface of the multiple solar cells, and the first PET film layer is bonded to the multiple solar cells through the first bonding layer. The back sheet includes a second bonding layer and a second PET film layer which are laminated; the second bonding layer is disposed between a second surface of the multiple solar cells and the second PET film layer, and the second bonding layer is configured to bond and fix the second PET film layer to the multiple solar cells. The sum of the thickness of the first PET film layer and the thickness of the second PET film layer is less than or equal to 150 microns; the sum of the thickness of the first bonding layer and the thickness of the second bonding layer is less than or equal to 200 microns.

In a third aspect, an embodiment of the present application further provides a recreational vehicle. The recreational vehicle includes a vehicle body and the photovoltaic awning according the second aspect, where the photovoltaic awning is configured to be fixed on a vertical side wall of the vehicle body.

According to the technical solutions of the embodiments of the present application, the sum of the thickness of the first PET film layer in the front sheet and the thickness of the second PET film layer in the back sheet is less than or equal to 150 microns, which is relatively small. In this manner, the requirements for electrical insulation and moisture barrier of photovoltaic power generation systems with the system voltage less than or equal to 300V are satisfied, so that the flexible photovoltaic module is applicable to low-voltage photovoltaic power generation systems. The thickness of the first PET film layer and the second PET film layer is relatively small, and the thickness of the first bonding layer and the second bonding layer is relatively small, so as to enhance the flexibility of the flexible photovoltaic module, and to avoid the problem of the photovoltaic module not being able to bend due to relatively thick polymer layers. In this manner, the flexible photovoltaic module can be applied to flexible products such as a flexible awning or a canopy of a recreational vehicle, thus the applicability of the flexible photovoltaic module is improved, and the user experience is enhanced.

### BRIEF DESCRIPTION OF DRAWINGS

FIG. 1 is a structural diagram of a flexible photovoltaic module according to an embodiment of the present application;
FIG. 2 is a structural diagram of another flexible photovoltaic module according to an embodiment of the present application;
FIG. 3 is a structural diagram of another flexible photovoltaic module according to an embodiment of the present application;
FIG. 4 is a structural diagram of another flexible photovoltaic module according to an embodiment of the present application;
FIG. 5 is a structural view of a photovoltaic awning according to an embodiment of the present application;
FIG. 6 is a structural view of another photovoltaic awning according to an embodiment of the present application;
FIG. 7 is a structural view of a photovoltaic awning in an extended state according to an embodiment of the present application;
FIG. 8 is a structural view of a photovoltaic awning in a retracted state according to an embodiment of the present application;
FIG. 9 is a structural diagram of a flexible solar cell according to an embodiment of the present application;
FIG. 10 is a structural view of another photovoltaic awning in an extended state according to an embodiment of the present application;
FIG. 11 is a sectional view of a solar cell module taken from a first viewpoint according to an embodiment of the present application;
FIG. 12 is a sectional view of a solar cell module taken from a second viewpoint according to an embodiment of the present application;
FIG. 13 is a perspective view of a reel according to an embodiment of the present application;
FIG. 14 is a structural view of another photovoltaic awning in an extended state taken from a side viewpoint according to an embodiment of the present application;
FIG. 15 is a structural view of another photovoltaic awning in an extended state according to an embodiment of the present application;
FIG. 16 is a partial structural view of a recreational vehicle with an extended photovoltaic awning according to an embodiment of the present application; and
FIG. 17 is a partial structural view of a recreational vehicle with a retracted photovoltaic awning according to an embodiment of the present application.

### DETAILED DESCRIPTION

Technical solutions in embodiments of the present application will be described in conjunction with drawings in the embodiments of the present application. Apparently, the embodiments described herein are part of embodiments of the present application. Based on the embodiments in the present application, all other embodiments obtained by those of ordinary skill in the art without creative work are within the protection scope of the present application.

In the description of the present application, it is to be understood that if terms such as "center", "longitudinal", "lateral", "length", "width", "thickness", "above", "below", "front", "back", "left", "right", "vertical", "horizontal", "top", "bottom", "inside", "outside", "clockwise", "counterclockwise", "axial", "radial" and "circumferential" appear, orientations or position relations indicated by these terms are orientations or position relations based on the drawings. These orientations or position relations are intended only to facilitate the description of the present application and simplify the description and not to indicate or imply that an apparatus or element referred to must have such specific orientations or must be configured or operated in such specific orientations. Thus, these orientations or position relations are not to be construed as limiting the present application.

Moreover, if terms such as "first" and "second" appear, these terms are used only for the purpose of description and are not to be construed as indicating or implying relative importance or implicitly indicating the number of technical features indicated. Therefore, a feature defined as a "first" feature or a "second" feature may expressly or implicitly include at least one this feature. As described herein, if the term "multiple" appears, "multiple" is defined as at least two, for example, two, three or the like, unless otherwise expressly limited.

In the present application, unless otherwise expressly specified and limited, if terms "mounted", "connected to each other", "connected" and "fixed" appear, these terms are to be understood in a broad sense. For example, these terms may refer to "securely connected", "detachably connected" or "integrated", may refer to "mechanically connected" or "electrically connected" or may refer to "connected directly", "connected indirectly through an intermediary", or "internally connected between two elements" or "interaction relations between two elements", unless otherwise expressly specified and limited. For those of ordinary skill in the art, meanings of the preceding terms in the present application can be understood according to situations.

In the present application, unless otherwise expressly specified and limited, when a first feature is described as "on" or "below" a second feature, the first feature and the second feature may be in direct contact or be in indirect contact via an intermediate feature. Moreover, when the first feature is described as "on", "above" or "over" the second feature, the first feature may be right on, above or over the second feature, the first feature may be obliquely on, above or over the second feature, or the first feature may be simply at a higher level than the second feature. When the first feature is described as "under", "below" or "underneath" the second feature, the first feature may be right under, below or underneath the second feature, the first feature may be obliquely under, below or underneath the second feature, or the first feature may be simply at a lower level than the second feature.

It is to be noted that when a component is described as being "fixed to" or "disposed on" another component, it may be directly on the particular component or intervening components may be present. When a component is described as being "connected to" another component, it may be directly connected to the particular component or intervening components may be present. The terms "vertical", "horizontal", "above", "below", "left", "right" and the like, as used in the present application, are only used for an illustrative purpose and are not the unique embodiments.

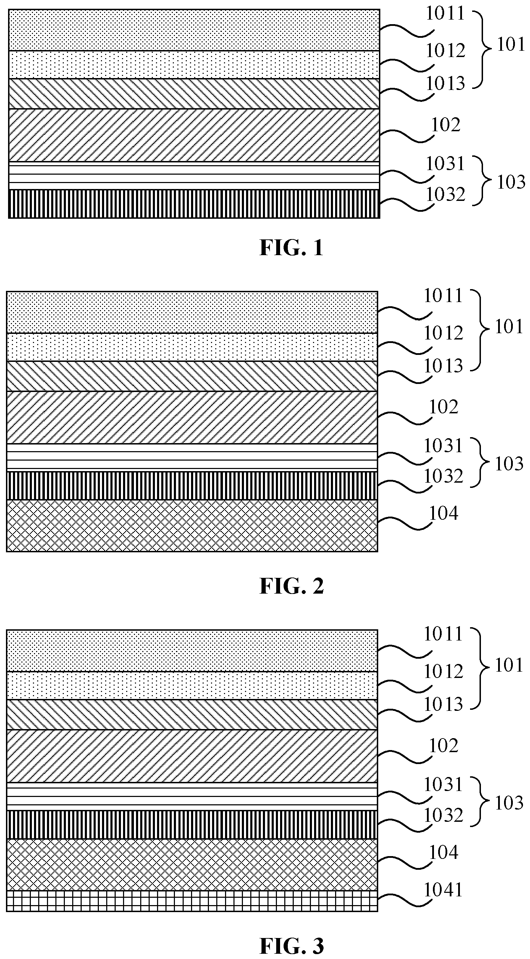

An embodiment of the present application provides a flexible photovoltaic module. The flexible photovoltaic module is applied to a photovoltaic power generation system with a system voltage less than or equal to 300V Optionally, the flexible photovoltaic module provided in the embodiment is applied to photovoltaic power generation systems with system voltages less than or equal to 100V, preferably less than or equal to 60V and more preferably less than or equal to 48V. FIG. 1 is a sectional structural diagram of a flexible photovoltaic module according to an embodiment of the present application. Referring to FIG. 1, the flexible photovoltaic module 10 includes a front sheet 101, solar cells 102 and a back sheet 103 which are laminated, where the solar cells 102 are located between the front sheet 101 and the back sheet 103; the front sheet 101 includes a polymer film 1011, a first polyethylene terephthalate (PET) film layer 1012 and a first bonding layer 1013 which are laminated; the first bonding layer 1013 is disposed on a first surface of the solar cells 102, and the first PET film layer 1012 is bonded to the solar cells 102 through the first bonding layer 1013; the back sheet 103 includes a second bonding layer 1031 and a second PET film layer 1032 which are laminated; the second bonding layer 1031 is disposed between a second surface of the solar cells 102 and the second PET film layer 1032, and the second bonding layer 1031 is configured to bond and fix the second PET film layer 1032 to the solar cells 102; and the sum of the thickness of the first PET film layer 1012 and the thickness of the second PET film layer 1032 is less than or equal to 150 microns; the sum of the thickness of the first bonding layer 1013 and the thickness of the second bonding layer 1031 is less than or equal to 200 microns.

The front sheet 101 has, for example, relatively high light transparency, with transmittance of over 85%, preferably over 90%, preferably over 95%, and more preferably over 98%, which is favorable for solar cells 102 receiving more light and converting solar energy into electric power. The front sheet 101 also serves to protect the solar cells 102 from damage caused by environment, such as high temperatures, low temperatures and rainwater. The front sheet 101 can also protect the solar cell 102 from damage caused by impact and other factors.

The polymer film 1011 has good cutting resistance and scratch resistance, which can achieve the effect of protecting the solar cells 102, avoiding damage to the solar cells 102 due to collisions or impact. For example, the polymer film 1011 may be a thin film made of organic polymer materials, such as vinyl copolymer, polyvinylidene fluoride (PVDF) or ethylene tetrafluoroethylene (ETFE) copolymer. The thickness of the polymer film 1011 is, for example, 25 microns to 200 microns. Optionally, the thickness of the polymer film 1011 is 150 microns.

The first PET film layer 1012 has relatively high transparency, facilitating the solar cells 102 to receive more light. The first PET film layer 1012 is electrically insulated. Moreover, the surface of the first PET film layer 1012 can be coated with a barrier layer, and the barrier layer is an inorganic film layer formed by, for example, a metal film layer or a silicon oxide layer. The barrier layer has water resistance and can avoid damage to the solar cells 102 caused by moisture in the air, providing further protection to the solar cells 102 and improving the reliability of the flexible photovoltaic module.

A solar cell 102 includes, for example, a solar cell element and wirings. The wirings can connect electrodes (including anode and cathode) of the solar cell element to an external electrical device (such as a lighting device or a display device). The solar cell element is, for example, an amorphous silicon solar cell element, an organic solar cell element or a compound semiconductor solar cell element. The solar cell element includes layer structures of, for example, an anode, a hole extraction layer, a photoelectric conversion layer, an electron extraction layer and a cathode. The photoelectric conversion layer can convert photons into electricity, thereby converting solar energy into electricity and supplying power to the external electrical device. The anode and the cathode in the solar cell element are transparent or semitransparent, which is favorable to light passing and absorbing. The solar cell 102, for example, is a flexible solar cell, so that the solar cell 102 can be bent. Therefore, the flexibility and bendability of the flexible photovoltaic module 10 can be improved. The solar cell 102 includes a first surface and a second surface which are opposite. The first surface of the solar cell 102 is, for example, a surface in contact with the front sheet 101, and the second surface of the solar cell 102 is, for example, a surface in contact with the back sheet 103.

The back sheet 103 has a supporting and protective effect on the solar cell 102. The back sheet 103 can be fixed on a support substrate, so that the flexible photovoltaic module 10 is applicable to different product forms and application scenarios. The second bonding layer 1031 bonds the back sheet 103 to the solar cells 102. The second PET film layer 1032 has the effect of electrical insulation and high weather resistance. Furthermore, the surface of the second PET film layer 1032 can be coated with a barrier layer. The barrier layer is an inorganic film layer formed by, for example, a metal film layer or a silicon oxide layer. The barrier layer has water resistance and can avoid damage to the solar cells 102 caused by moisture in the air. The first PET film layer 1012 and the second PET film layer 1032 have electrical insulation. However, if the thickness of the first PET film layer 1012 and the thickness of the second PET film layer 1032 are set too large, the electrical insulation of the photovoltaic module is too high. As a result, the photovoltaic module is applicable to high-voltage photovoltaic power generation systems, but not to low-voltage photovoltaic power generation systems. Moreover, if the first PET film layer 1012 and the second PET film layer 1032 are set to be difficult to bend, the photovoltaic module will be less flexible. Optionally, the sum of the thickness of the first PET film layer 1012 and the thickness of the second PET film layer 1032 is less than or equal to 120 microns. Optionally, the sum of the thickness of the first PET film layer 1012 and the thickness of the second PET film layer 1032 is less than or equal to 100 microns. Optionally, the sum of the thickness of the first PET film layer 1012 and the thickness of the second PET film layer 1032 is less than or equal to 80 microns.

The first bonding layer 1013 and the second bonding layer 1031 are configured to bond the front sheet 101 to the solar cells 102 and the back sheet 103 to the solar cells 102 respectively, and the first bonding layer 1013 and the second bonding layer 1031 may be composed of the same or different materials. Optionally, the material of the first bonding layer 1013 and the material of the second bonding layer 1031 are at least one of polyvinyl butyral, polyolefin, ethylene vinyl acetate copolymer, fluorine resin, silicone resin or acrylic resin. The inventor found that in addition to the PET film layers, bonding layers also have a negative impact on the flexibility and bendability of the photovoltaic module. Therefore, in the embodiment, the sum of the thickness of the first bonding layer 1013 and the thickness of the second bonding layer 1031 is less than or equal to 200 microns. Optionally, the sum of the thickness of the first bonding layer 1013 and the thickness of the second bonding layer 1031 is less than or equal to 150 microns. Optionally, the sum of the thickness of the first bonding layer 1013 and the thickness of the second bonding layer 1031 is less than or equal to 100 microns. Therefore, the sum of the thickness of the first bonding layer 1013 and the thickness of the second bonding layer 1031 is reduced, so that the flexibility and bendability of the photovoltaic module can be further improved while the mechanical strength requirements are satisfied.

Therefore, the sum of the thickness of the first PET film layer 1012 and the thickness of the second PET film layer 1032 is relatively small, and the sum of the thickness of the first bonding layer 1013 and the thickness of the second bonding layer 1031 is less than 200 microns, which means that thicknesses of PET film layers and thicknesses of bonding layers are relatively small. In this manner, the flexibility of the flexible photovoltaic module can be improved, the problem that relatively thick PET substrates or bonding layers cause the photovoltaic module to be unable to bend is avoided, and thus the flexible photovoltaic module can be bent and rolled up with a smaller radius of curvature. The flexible photovoltaic module disclosed in the embodiment may be fixedly mounted on flexible products such as a flexible awning or a canopy of a recreational vehicle. Therefore, the applicability of the flexible photovoltaic module is improved, and the user experience is enhanced. According to the technical solution of the embodiment, the sum of the thickness of the first PET film layer 1012 and the thickness of the second PET film layer 1032 is less than or equal to 150 microns, the sum of the thickness of the first bonding layer 1013 and the thickness of the second bonding layer 1031 is less than or equal to 200 microns, and the thickness of the first PET film layer 1012, the thickness of the second PET film layer 1032, the thickness of the first bonding layer 1013 and the thickness of the second bonding layer 1031 are all larger than 0, so that the total thickness of the first PET film layer 1012 and the second PET film layer 1032 and the total thickness of the first bonding layer 1013 and the second bonding layer 1031 are relatively small. In this manner, while the requirements for electrical insulation, moisture barrier and mechanical strength of low-voltage photovoltaic power generation systems with the system voltage less than or equal to 300V are satisfied, better flexibility and bendability are provided for the photovoltaic module, so that the flexible photovoltaic module can be bent and rolled up with a smaller radius of curvature (1cm to 10cm).

According to the technical solution of the embodiment, the sum of the thickness of the first PET film layer in the front sheet and the thickness of the second PET film layer in the back sheet is less than or equal to 150 microns, and the sum of the thickness of the first bonding layer and the thickness of the second bonding layer is less than or equal to 200 microns, that is, thicknesses are relatively small. In this manner, while the requirements for electrical insulation and moisture barrier of photovoltaic power generation systems with the system voltage less than or equal to 300V are satisfied, the flexibility and bendability of the flexible photovoltaic module are greatly improved. The thickness of the first PET film layer and the second PET film layer is relatively small, and the thickness of the first bonding layer and the second bonding layer is also relatively small, so as to enhance the flexibility of the flexible photovoltaic module, and to avoid the photovoltaic module not being able to bend due to multiple relatively thick functional layers. In this manner, the flexible photovoltaic module can be bent and rolled up with a smaller radius of curvature (1cm to 10cm), so that the flexible photovoltaic module can be applied to flexible products such as a flexible awning or a canopy of a recreational vehicle, thus the applicability of the flexible photovoltaic module is improved, and the user experience is enhanced.

FIG. 2 is a sectional structural diagram of another flexible photovoltaic module according to an embodiment of the present application. Optionally, as shown in FIG. 2, the flexible photovoltaic module 10 further includes a fabric layer 104. The fabric layer 104 is located on a side of the back sheet 103 facing away from the solar cells 102, and the fabric layer 104 is bonded and fixed to the back sheet 103.

The fabric layer 104 is a flat and soft piece of fabric composed of long and thin flexible fabrics that are crossed, wound and connected. The fabric layer 104 is, for example, felt fabric, plain weave fabric or twill fabric. The fabric layer 104 has relatively high flexibility. The fabric layer 104 is integrated on the back sheet 103, so that the position of a neutral layer of the entire flexible photovoltaic module can be adjusted to avoid stress being concentrated on the solar cells 102 during bending, and thus the flexibility and reliability of the flexible photovoltaic module 10 are further improved. Moreover, the fabric layer 104 and the flexible photovoltaic module are integrated, so that the application scenarios of the product are expanded. For example, the flexible photovoltaic module integrated with the fabric layer 104 may be directly used as shading fabrics of a flexible awning or a canopy of a recreational vehicle. The canopy of the recreational vehicle is taken as an example. When the canopy is extended, the flexible photovoltaic module 10 integrated on the canopy can generate electricity to provide electricity for an electrical device or charge an energy storage battery. When the recreational vehicle is moving, the flexible photovoltaic module 10 can be rolled up and stored on the side of the body of the recreational vehicle. As a result, the flexible photovoltaic module 10 integrated with the fabric layer can be easily extended and stored, improving the applicability and user experience of the flexible photovoltaic module 10.

In some embodiments, the fabric layer 104 may be fixed together to the back sheet 103 through the bonding layer. In some other implementations, the fabric layer 104 may be thermal-fused with the back sheet 103, for example, by heat welding, so that the fabric layer 104 is bonded and fixed to the back sheet 103. In this manner, the thickness of the flexible photovoltaic module 10 is reduced, the weight and stiffness of the flexible photovoltaic module 10 are reduced, and the manufacturing process of the photovoltaic module is simplified. Optionally, the fabric layer 104 is fixed to the back sheet 103 by heating and fusing, which is conducive to further enhancing the flexibility of the flexible photovoltaic module 10 and the bendability of the flexible photovoltaic module 10. Moreover, the use of materials is reduced, so that preparation costs of the flexible photovoltaic module 10 are reduced. The fabric layer 104 is fixed to the back sheet 103 in the manner of heat welding, so that the connection between the fabric layer 104 and the back sheet 103 can be more firm, the problem can be avoided that the fabric layer 104 peels off from the back sheet 103 during use, and the problem can also be avoided that the fabric layer 104 falls off due to melting of the bonding layer at a relatively high temperature. Therefore, the reliability of the flexible photovoltaic module 10 can be improved, and the user experience can be enhanced.

On the basis of the preceding technical solutions, FIG. 3 is a sectional structural diagram of another flexible photovoltaic module according to an embodiment of the present application. Optionally, as shown in FIG. 3, an electrical insulation coating 1041 is disposed on a surface of the fabric layer 104 away from the back sheet 103. The material of the fabric layer 104 includes inorganic fibers or organic fibers.

In some implementations, the material of the fabric layer 104 includes inorganic fibers, such as glass fibers, quartz glass fibers, boron fibers or ceramic fibers. In some other embodiments, the material of the fabric layer 104 may also include organic fibers, such as polyester fibers, acrylic fibers, nylon fibers or polypropylene fibers. The electrical insulation coating 1041 is formed, for example, in a manner that the surface of the fabric layer 104 away from the back sheet 103 is coated or impregnated with electrical insulation polymer. The electrical insulation coating 1041 is, for example, a vinyl coating. The vinyl coating has the characteristics of good weather resistance, good chemical corrosion resistance, good water resistance, good insulation, good mildew resistance and good flexibility. The electrical insulation coating 1041 can not only provide electrical insulation, but also enhance the flexibility of the flexible photovoltaic module 10, and can protect the solar cells 102. The electrical insulation coating 1041 is disposed on the fabric layer 104, so that the electrical insulation performance of the flexible photovoltaic module 10 can be further improved, satisfying the electrical insulation requirements of photovoltaic power generation systems with the system voltage less than or equal to 300V

In some other implementations, the electrical insulation coating 1041 may also be located on the surface of the fabric layer 104 facing away from the back sheet 103, which is not limited in the embodiment.

It is to be noted that the setting of the electrical insulation coating 1041 is optional. If the electrical insulation of the flexible photovoltaic module 10 satisfies the requirements of the photovoltaic power generation system, it is not necessary to dispose the electrical insulation coating 1041. If the electrical insulation of the flexible photovoltaic module 10 needs to be improved, the electrical insulation coating 1041 may be disposed on the fabric layer 104, which is not limited in the embodiment.

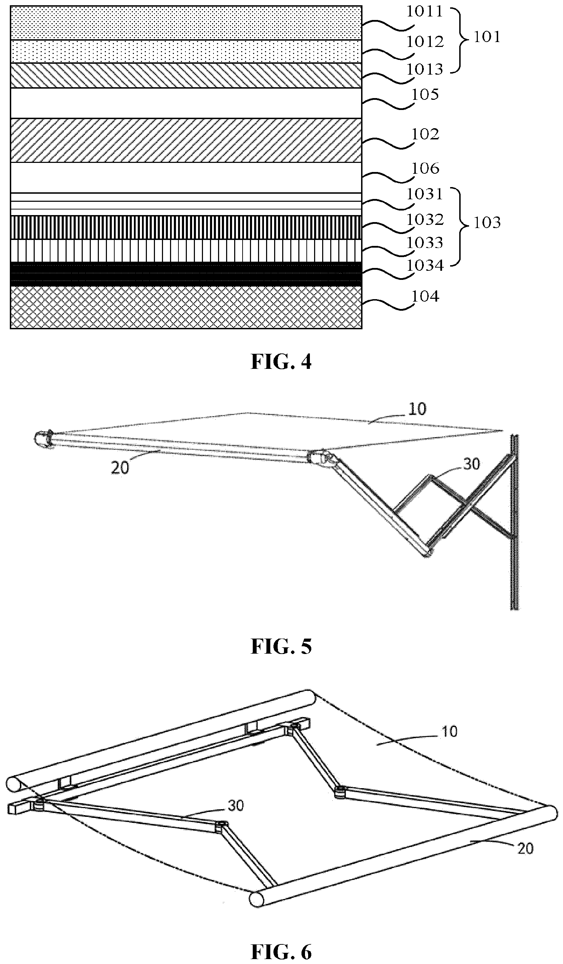

On the basis of the preceding technical solutions, FIG. 4 is a sectional structural diagram of another flexible photovoltaic module according to an embodiment of the present application. Optionally, as shown in FIG. 4, the flexible photovoltaic module further includes a first sealing layer 105 and a second sealing layer 106. The first sealing layer 105 is located between the solar cells 102 and the front sheet 101, and the second sealing layer 106 is located between the solar cells 102 and the back sheet 103.

The first sealing layer 105 and the second sealing layer 106 can prevent damage to the solar cells 102 due to collisions and can withstand high temperatures, preventing damage to the solar cells 102 due to high temperature shocks. The first sealing layer 105 and the second sealing layer 106 can prevent penetration of moisture in the air, thus having good water resistance to prevent damage to the solar cells 102 due to damp or water immersion. The first sealing layer 105 is disposed between the solar cells 102 and the front sheet 101, so that the first sealing layer 105 can protect the solar cells on a side of the solar cells close to the front sheet 101. The second sealing layer 106 is disposed between the solar cells 102 and the back sheet 103, so that the second sealing layer 106 can protect the solar cells 102 on a side of the solar cells 102 away from the front sheet 101. In this manner, multi-directional protection is formed for the solar cells 102, and the flexible photovoltaic module has better high temperature resistance and water resistance, which is favorable to improving the reliability of the flexible photovoltaic module.

Optionally, the melting point of the first sealing layer 105 and the second sealing layer 106 is higher than 100°C, and the material of the first sealing layer 105 and the second sealing layer 106 includes at least one of polyvinyl butyral, polyolefin, ethylene vinyl acetate copolymer, fluorine resin, silicone resin or acrylic resin.

The first sealing layer 105 is disposed on a surface of the front sheet 101 close to the solar cells 102 through, for example, the lamination process to bond and fix the front sheet 101 to the solar cells 102, achieving the effect of protecting the solar cells 102. The second sealing layer 106 is disposed on a surface of the back sheet 103 close to the solar cells 102 through, for example, the lamination process to bond and fix the back sheet 103 to the solar cells 102, achieving the effect of protecting the solar cells 102. Considering that the relatively high temperature of the solar cell 102 after reception of sunlight and the solar cell 102 also generates heat when generating electricity, the melting point of the first sealing layer 105 and the melting point of the second sealing layer 106 are set to be higher than 100°C, for example, are set to 150°C, avoiding melting of the first sealing layer 105 and the second sealing layer 106 by heat. In this manner, the solar cell 102 can be protected, and the flexible photovoltaic module can have better high temperature resistance. The material of the first sealing layer 105 and the material of the second sealing layer 106 may include at least one of polyvinyl butyral, polyolefin, ethylene vinyl acetate copolymer, fluorine resin, silicone resin or acrylic resin or may include a polymer of at least two of polyvinyl butyral, polyolefin, ethylene vinyl acetate copolymer, silicone resin and acrylic resin so that the high temperature resistance of the first sealing layer 105 and the second sealing layer 106 can be improved.

Optionally, referring to FIG. 4, the sum of the thickness of the first bonding layer 1013, the thickness of the second bonding layer 1031, the thickness of the first sealing layer 105 and the thickness of the second sealing layer 106 is less than or equal to 200 microns. In this manner, the sum thickness of the first bonding layer 1013, the second bonding layer 1031, the first sealing layer 105 and the second sealing layer 106 is relatively small, so that the first bonding layer 1013, the second bonding layer 1031, the first sealing layer 105 and the second sealing layer 106 are easy to bend. Therefore, it is avoided that the flexible photovoltaic module is difficult to bend due to the relatively large thickness of the first sealing layer 105 and the second sealing layer 106, the flexibility of the flexible photovoltaic module is improved, and thus the flexible photovoltaic module can be bent and rolled up with a smaller radius of curvature.

In some other implementations, to enhance the sealing and protective effect on the solar cells 102, the first sealing layer 105 and the second sealing layer 106 may be formed in other shapes, such as fully covering the solar cells 102, thereby achieving the effect of all-round protection on the solar cells 102. FIG. 4 only exemplarily illustrates, but not limits, the shape of the first sealing layer 105 and the shape of the second sealing layer 106.

In another implementation solution of the embodiment, on the basis of the preceding technical solutions, optionally, referring to FIG. 4, the back sheet 103 further includes a meal layer 1033 and a third PET film layer 1034. The metal layer 1033 is located on a surface of the second PET film layer 1032 facing away from the solar cells 102. The third PET film layer 1034 is located on a surface of the metal layer 1033 facing away from the second PET film layer 1032. The sum of the thickness of the first PET film layer 1012, the thickness of the second PET film layer 1032 and the thickness of the third PET film layer 1034 is less than or equal to 150 microns.

The metal layer 1033 has excellent water resistance performance, which can further avoid damage to the solar cells 102 caused by moisture in the air. The metal layer 1033 is disposed between the second PET film layer 1032 and the third PET film layer 1034, which can improve the electrical insulation of the flexible photovoltaic module, avoid leakage of electricity in the flexible photovoltaic module, prevent current loss, and also avoid interference from stray currents on the solar cells 102. The metal layer 1033 is formed by metal so that the metal layer 1033 has a high density and good water resistance, avoiding damage to solar cells 102 caused by rainwater and achieving the further protection effect on the solar cells 102. The metal layer 1033 may include aluminum foil, copper foil or other metal foil, which is not limited here. Through the third PET film layer 1034, the electrical insulation performance and moisture barrier performance of the flexible photovoltaic module can be further improved.

The sum of the thickness of the first PET film layer 1012, the thickness of the second PET film layer 1032 and the thickness of the third PET film layer 1034 is less than or equal to 150 microns. Optionally, the sum of the thickness of the first PET film layer 1012, the thickness of the second PET film layer 1032 and the thickness of the third PET film layer 1034 is less than or equal to 120 microns. Optionally, the sum of the thickness of the first PET film layer 1012, the thickness of the second PET film layer 1032 and the thickness of the third PET film layer 1034 is less than or equal to 100 microns. Optionally, the sum of the thickness of the first PET film layer 1012, the thickness of the second PET film layer 1032 and the thickness of the third PET film layer 1034 is less than or equal to 80 microns. In this manner, the total thickness of the PET substrates of the flexible photovoltaic module 10 is relatively small, which is favorable to achieving bending and rolling up of the flexible photovoltaic module 10 with a smaller radius of curvature. Moreover, the thickness of the metal layer 1033 may also be relatively small so that the metal layer 1033 is easy to bend, which is conducive to further improving the flexibility and bendability of the flexible photovoltaic module 10.

Referring to FIG. 4, the thickness of the first PET film layer 1012, the thickness of the second PET film layer 1032 and the thickness of the third PET film layer 1034 are all 20 microns to 50 microns.

The thickness of the first PET film layer 1012, the thickness of the second PET film layer 1032 and the thickness of the third PET film layer 1034 are all 20 microns to 50 microns. If the thickness of the first PET film layer 1012, the thickness of the second PET film layer 1032 and the thickness of the third PET film layer 1034 are all greater than 50 microns, the sum thickness of the first PET film layer 1012, the second PET film layer 1032 and the third PET film layer 1034 is relatively large and not easy to bend, so that the flexibility of the flexible photovoltaic module is relatively small, which is not conducive to the mounting of the flexible photovoltaic module. If the thickness of the first PET film layer 1012, the thickness of the second PET film layer 1032 and the thickness of the third PET film layer 1034 are all less than 20 microns, the sum thickness of the first PET film layer 1012, the second PET film layer 1032 and the third PET film layer 1034 is too small to satisfy the insulation requirements of a photovoltaic power generation system with the system voltage less than or equal to 300V, which affects the current generated by the solar cells 102 and is not conducive to the power supply of the flexible photovoltaic module 10 to the electrical device. Moreover, if the thicknesses of the PET film layers are too small, the PET film layers are difficult to prepare. Therefore, the thickness of the first PET film layer 1012, the thickness of the second PET film layer 1032 and the thickness of the third PET film layer 1034 are all 20 microns to 50 microns. In this manner, good electrical insulation can be achieved while the flexibility of the flexible photovoltaic module 10 can be improved, which is conducive to enhancing the applicability and reliability of the flexible photovoltaic module 10.

In some other implementations, optionally, the thickness of the first PET film layer 1012, the thickness of the second PET film layer 1032 and the thickness of the third PET film layer 1034 may be 25 microns to 50 microns. Optionally, the thickness of the first PET film layer 1012, the thickness of the second PET film layer 1032 and the thickness of the third PET film layer 1034 may be 25 microns to 40 microns. In this manner, it is avoided that the sum thickness of the first PET film layer 1012, the second PET film layer 1032 and the third PET film layer 1034 is relatively small, so that a good insulation effect is achieved. The insulation requirements of a photovoltaic power generation system with the system voltage less than or equal to 300V are satisfied, and thus the flexible photovoltaic module 10 is applicable to low-voltage photovoltaic power generation systems and easy to prepare. Moreover, good water resistance and cutting resistance can be achieved, so that the solar cells 102 can be protected better.

Optionally, referring to FIG. 4, the metal layer 1033 includes aluminum foil, the thickness of the aluminum foil is 5 microns to 50 microns.

The metal layer 1033 is, for example, aluminum foil. Compared to other metal (such as copper and iron), aluminum foil has relatively high flexibility and is easy to bend, which is conducive to further enhancing the flexibility of the flexible photovoltaic module 10. The aluminum foil has a relatively small weight, so that the weight of the flexible photovoltaic module 10 is relatively small. Therefore, the flexible photovoltaic module 10 can be mounted on electrical devices with a relatively small load-bearing capacity, so that the applicability of the flexible photovoltaic module 10 is improved. Moreover, the thickness of the aluminum foil is 5 microns to 50 microns. If the thickness of the aluminum foil is greater than 50 microns, the thickness of the aluminum foil is relatively large and is not easy to bend, so that the flexibility of the flexible photovoltaic module 10 is relatively small, which is not conducive to the mounting of the flexible photovoltaic module 10. If the thickness of the aluminum foil is less than 5 microns, the thickness of the aluminum foil is too small to achieve good water resistance. The thickness of the aluminum foil may be, optionally, 5 microns to 30 microns, 5 microns to 20 microns, or 5 microns to 10 microns. Therefore, good water resistance can be achieved while the flexibility of the flexible photovoltaic module 10 can be improved, which is conducive to improving the applicability and reliability of the flexible photovoltaic module 10.

Optionally, referring to FIG. 4, the thickness of the fabric layer 104 is 100 microns to 10 millimeters.

If the thickness of the fabric layer 104 is greater than 10 millimeters, the thickness of the fabric layer 104 is too large and not easy to bend, which is not conducive to the mounting of the flexible photovoltaic module. If the thickness of the fabric layer 104 is less than 100 microns, the thickness of the fabric layer 104 is too small, so that the flexible photovoltaic module 10 cannot be firmly mounted on the electrical device. The thickness of the fabric layer 104 is set to be 100 microns to 10 millimeters. Optionally, the thickness of the fabric layer 104 is 100 microns to 5 millimeters. Optionally, the thickness of the fabric layer 104 is 200 microns to 5 millimeters. In this manner, the fabric layer 104 can be easier to bend and the flexible photovoltaic module 10 can be firmly mounted on a surface of the support substrate. The thickness of the fabric layer 104 is set to be 100 microns to 10 millimeters, so that when the flexible photovoltaic module 10 is bent or rolled up, the fabric layer 104 bears most of the compressive stress, the front sheet bears most of the tensile stress, and the solar cells 102 are in the neutral layer with stress equal to or close to zero. Therefore, the problem can be effectively avoided that hidden cracks appearing in some functional layers (such as electrodes and the photoelectric conversion layer 313) of the solar cells 102 during the repeated bending process of the flexible photovoltaic module 10 lead to failure.

Optionally, the thickness of the first PET film layer 1012 is greater than or equal to the sum of the thickness of the second PET film layer 1032 and the thickness of the third PET film layer 1034. In an optional implementation, the thickness of the first PET film layer 1012 is 50 microns, and the thickness of the second PET film layer 1032 and the thickness of the third PET film layer 1034 are both 25 microns. In the implementation, the back sheet 103 uses the configuration of two layers of PET films and the metal foil, so that the electrical insulation and moisture resistance performance of the back sheet 103 are greatly improved. To further enhance the flexibility and bendability of the photovoltaic module 10, the thickness of the first PET film layer 1012 is set to be greater than or equal to the sum of the thickness of the second PET film layer 1032 and the thickness of the third PET film layer 1034, so that the thickness of the back sheet 103 can be further reduced without affecting the electrical insulation and moisture barrier performance. Moreover, the position of the neutral layer is adjusted upward, and the solar cells 102 are placed in the neutral layer with relatively low stress, so that the flexibility and reliability of the photovoltaic module are increased at the same time. When the flexible photovoltaic module 10 is applied to flexible awnings or canopy products of recreational vehicles, the risk can be avoided that hidden cracks appearing in solar cells lead to product failure during repeatedly rolling or wind-driven waving of the module, and thus the lifespan of the product is effectively extended.

In another implementation, the thickness of the first PET film layer 1012 is less than the sum of the thickness of the second PET film layer 1032 and the thickness of the third PET film layer 1034. For example, the thickness of the first PET film layer, the thickness of the second PET film layer and the thickness of the third PET film layer are equal. For example, the thickness of the first PET film layer, the thickness of the second PET film layer and the thickness of the third PET film layer are all 25 microns. In this manner, the thickness of any PET film layer is relatively small, which is conducive to further improving the flexibility and bendability of the flexible photovoltaic module 10, and better achieving bending and rolling with a small radius of curvature (such as 2cm to 25cm) of the flexible photovoltaic module 10.

Optionally, referring to FIG. 4, the solar cells 102 may be thin-film solar cells. For example, the solar cells 102 may be copper indium gallium selenide based thin-film solar cells or perovskite based solar cells.

In some implementations, the photoelectric conversion layer 313 of the solar cell 102 includes a light absorbing layer, which can absorb photons, facilitating the conversion of light into electricity by the solar cell 102. The light absorbing layer of the solar cell 102 includes the compound CuGaSe₂ composed of copper, gallium and selenium in a ratio of 1:1:2, so that the photoelectric conversion efficiency of the solar cell 102 can be improved. In some other implementations, the light absorbing layer of the solar cell 102 may also include the compound CuInSe₂ composed of copper, indium and selenium, or may include a mixture of CuGaSe₂ and CuInSe₂.

In some other implementations, the solar cell 102 includes a flexible substrate and a perovskite cell located on the flexible substrate. The thickness of the solar cell 102 is, for example, 30 microns to 5 millimeters. Optionally, the thickness of the solar cell 102 is, for example, 50 microns to 4 millimeters. Optionally, the thickness of the solar cell 102 is, for example, 100 microns to 2 millimeters. Optionally, the thickness of the solar cell 102 is, for example, 500 microns to 1.5 millimeters. In this manner, the thickness of the solar cell 102 is relatively small, which is conducive to achieving bending and rolling up with a relatively small radius of curvature. In the implementation, the light absorbing layer of the solar cell 102 includes an organic metal halide perovskite semiconductor. For example, a material of the light absorbing layer may be CH₃NH₃PbX₃ (X=I⁻, Br⁻ or Cl⁻).

According to the technical solution of the embodiment, thicknesses of PET film layers and thicknesses of bonding layers are set smaller, so that better flexibility and bendability can be achieved for the photovoltaic module while the requirements for electrical insulation, moisture barrier and mechanical strength of low-voltage photovoltaic power generation systems with the system voltage less than or equal to 300V are satisfied, and thus the flexible photovoltaic module can be bent and rolled up with a smaller radius of curvature (1cm to 10cm). Moreover, the thickness of the aluminum foil is set to 5 microns to 10 microns, so that good water resistance can be achieved while the flexibility of the flexible photovoltaic module 10 can be improved. The fabric layer 104 is disposed, and the thickness of the fabric layer 104 is 100 microns to 10 millimeters, so that the fabric layer 104 is easy to bend, and bending and rolling up with a relatively small radius of curvature can be achieved. The sum thickness of the first bonding layer 1013, the second bonding layer 1031, the first sealing layer 105 and the second sealing layer 106 is relatively small, so that these layers are relatively easy to bend, and thus the flexibility of the flexible photovoltaic module 10 is further improved. Therefore, the flexible photovoltaic module 10 provided in the embodiment of the present application can satisfy the electrical insulation and moisture barrier requirements of photovoltaic power generation systems with the system voltage less than or equal to 300V, so that the flexible photovoltaic module 10 is applicable to low-voltage photovoltaic power generation systems. Moreover, the flexibility of the flexible photovoltaic module 10 is relatively high, so that the flexible photovoltaic module 10 can be mounted on flexible products and can be bent and rolled up with a relatively small radius of curvature, and thus the applicability of the flexible photovoltaic module 10 is improved.

Embodiments of the present application are provided through examples rather than limitations as follows.

### Embodiment 1

Materials and structures for preparing the flexible photovoltaic module 10 in this embodiment are described below.
1. A front sheet is provided. The front sheet includes a polymer film, a first PET film layer and a first bonding layer which are laminated. The polymer film uses an ETFE thin film with the thickness of 150 microns, the thickness of the first PET film layer is 50 microns, and the first bonding layer uses an ethylene vinyl acetate (EVA) adhesive film with the thickness of 100 microns.
2. A back sheet is provided. The back sheet includes a second bonding layer and a second PET film layer which are laminated. The thickness of the second PET film layer is 50 microns, and the second bonding layer uses an EVA adhesive film with the thickness of 100 microns.
3. Solar cells are provided. The solar cells in the embodiment are composed of multiple solar cell modules connected in series and parallel with each other. Each solar cell module uses a copper indium gallium selenide (CIGS) flexible thin-film solar cell based on a stainless steel substrate, and the total thickness of the flexible thin-film solar cell is 330 microns, and circuits are preset in the solar cell modules.

The method for preparing the flexible photovoltaic module in the embodiment is described below.
1. The front sheet and the back sheet are pre-prepared separately. In a vacuum laminator, the pre-prepared front sheet and back sheet are separately acquired through lamination according to the lamination design of the front sheet and the back sheet. The lamination temperature is 100°C, the lamination pressure is set as standard atmospheric pressure, and the lamination time is 5 minutes. The pre-prepared front sheet and back sheet are cut according to the size of the flexible photovoltaic module.
2. Lamination is performed in the vacuum laminator in a lamination order of the back sheet, the solar cells and the front sheet, with the lamination temperature of 160°C, the lamination pressure is set as a standard atmospheric pressure, and the lamination time is set as 6 minutes.

### Embodiment 2

Except a new back sheet used for replacing the back sheet in Embodiment 1, other materials, structures and the preparation method of the flexible photovoltaic module in the embodiment are consistent with materials, structures and the preparation method of the flexible photovoltaic module in Embodiment 1.

The back sheet used in the embodiment includes a second bonding layer, a second PET film layer, an aluminum foil layer and a third PET film layer which are laminated. The thickness of the second PET film layer is 50 microns, the second bonding layer uses an EVA adhesive film with the thickness of 100 microns, the thickness of the aluminum foil layer is 20 microns, and the thickness of the third PET film layer is 50 microns.

### Embodiment 3

Except a newly added fabric layer, other materials, structures and the preparation method of the flexible photovoltaic module in the embodiment are consistent with materials, structures and the preparation method of the flexible photovoltaic module in Embodiment 2.

In the embodiment, acrylic fibers coated with a vinyl material coating on the surface are used as the fabric layer, and the flexible photovoltaic module prepared in Embodiment 2 is fixed to the vinyl material coating through heat welding. The thickness of the fabric layer is 2000 microns.

### Comparative Example 1

Except a new front sheet and a new back sheet used for replacing the front sheet and the back sheet in Embodiment 1, other materials, structures and the preparation method of the flexible photovoltaic module in the comparative example are consistent with materials, structures and the preparation method of the flexible photovoltaic module in Embodiment 1.

The front sheet used in the comparative example includes a polymer film, a first PET film layer and a first bonding layer which are laminated. The polymer film uses an ETFE thin film with the thickness of 150 microns, the thickness of the first PET film layer is 150 microns, and the first bonding layer uses an EVA adhesive film with the thickness of 200 microns.

The back sheet used in the comparative example includes a second bonding layer and a second PET film layer which are laminated. The thickness of the second PET film layer is 150 microns, and the second bonding layer uses an EVA adhesive film with the thickness of 200 microns.

### Comparative Example 2

Except a thicker first bonding layer and a thicker second bonding layer used for replacing the first bonding layer in the front sheet and the second bonding layer in the back sheet in Embodiment 1, other materials, structures and the preparation method of the flexible photovoltaic module in the comparative example are consistent with materials, structures and the preparation method of the flexible photovoltaic module in Embodiment 1.

In the comparative example, the thickness of the first bonding layer is 200 microns, and the thickness of the second bonding layer is 200 microns.

### Comparative Example 3

Except a new front sheet and a new back sheet used for replacing the front sheet and the back sheet in Embodiment 1, other materials, structures and the preparation method of the flexible photovoltaic module in the comparative example are consistent with materials, structures and the preparation method of the flexible photovoltaic module in Embodiment 1.

The front sheet used in the comparative example includes a polymer film, a first PET film layer and a first bonding layer which are laminated. The polymer film uses an ETFE thin film with the thickness of 150 microns, the thickness of the first PET film layer is 150 microns, and the first bonding layer uses an EVA adhesive film with the thickness of 200 microns.

The back sheet used in the comparative example includes a second bonding layer, a second PET film layer, an aluminum foil layer and a third PET film layer which are laminated. The thickness of the second PET film layer is 50 microns, the second bonding layer uses an EVA adhesive film with the thickness of 100 microns, the thickness of the aluminum foil layer is 20 microns, and the thickness of the third PET film layer is 50 microns.

### Comparative example 4

Except a new front sheet and a new back sheet used for replacing the front sheet and the back sheet in Embodiment 1, other materials, structures and the preparation method of the flexible photovoltaic module in the comparative example are consistent with materials, structures and the preparation method of the flexible photovoltaic module in Embodiment 1.

The front sheet used in the comparative example includes a polymer film, a first PET film layer and a first bonding layer which are laminated. The polymer film uses an ETFE thin film with the thickness of 150 microns, the thickness of the first PET film layer is 150 microns, and the first bonding layer uses an EVA adhesive film with the thickness of 200 microns.

The back sheet used in the comparative example includes a second bonding layer, a second PET film layer, an aluminum foil layer and a third PET film layer which are laminated. The thickness of the second PET film layer is 150 microns, the second bonding layer uses an EVA adhesive film with the thickness of 200 microns, the thickness of the aluminum foil layer is 20 microns, and the thickness of the third PET film layer is 150 microns.

The back sheet in the comparative example further integrates acrylic fibers coated with a vinyl material coating on the surface as a fabric layer. The thickness of the fabric layer is 2000 microns, and the preparation method of the fabric layer is the same as the preparation method in Embodiment 3.

**Table 1 Comparison table of evaluation results of embodiments and evaluation results of comparative examples**

| | Total thickness of PET film layers (micron) | Total thickness of bonding layers (micron) | Thickness of fabric (micron) | Evaluation results | |
|---|---|---|---|---|---|
| | | | | Appearance changes when the rolling radius is 5cm | Minimum rolling radius |
| Embodiment 1 | 100 | 200 | - | No change | <3cm |
| Embodiment 2 | 150 | 200 | - | No change | <4cm |
| Embodiment 3 | 150 | 200 | 2000 | No change | <4cm |
| Comparative example 1 | 300 | 400 | - | Wrinkled and cracked | >25cm |
| Comparative example 2 | 100 | 400 | - | Wrinkled | 11cm |
| Comparative example 3 | 250 | 300 | - | Wrinkled and cracked | >13cm |
| Comparative example 4 | 450 | 400 | 2000 | Broken | >50cm |

Table 1 is a comparison table of evaluation results of embodiments and evaluation results comparative examples. The minimum rolling radium in Table 1 denotes the rolling radius when a significant change appears in the appearance of the flexible photovoltaic module during a rolling test. The content described below can be concluded according to the evaluation results shown in Table 1. The total thickness of PET film layers and the total thickness of bonding layers in the front sheet and the back sheet are designed, so that better flexibility and bendability can be provided for the photovoltaic module, the flexible photovoltaic module can be bent and rolled up with a smaller radius of curvature (1cm to 10cm), and thus the feasibility of the integrated application of the flexible photovoltaic module on awnings is provided.

In an optional embodiment of the present application, the flexible photovoltaic module 10 is composed of a front sheet 101, a first sealing layer 105, solar cells 102, a second sealing layer 106 and a back sheet 103 which are laminated. The solar cells 102 are located between the front sheet 101 and the back sheet 103, the first sealing layer 105 is located between the solar cells 102 and the front sheet 101, and the second sealing layer 106 is located between the solar cells 102 and the back sheet 103. The front sheet 101 is composed of a polymer film 1011, a first PET film layer 1012 and a first bonding layer 1013 which are laminated. The first bonding layer 1013 is disposed on a first surface of the solar cells 102, and the first PET film layer 1012 is bonded to the solar cells 102 through the first bonding layer 1013. The back sheet 103 is composed of a second bonding layer 1031, a second PET film layer 1032, a metal layer 1033 and a third PET film layer 1034 which are laminated. The second bonding layer 1031 is disposed between a second surface of the solar cells 102 and the second PET film layer 1032, and the second bonding layer 1031 is configured to bond and fix the second PET film layer 1032 to the solar cells 102. The metal layer 1033 is located on a surface of the second PET film layer 1032 away from the solar cells 102. The third PET film layer 1034 is located on a surface of the metal layer 1033 away from the second PET film layer 1032. The sum of the thickness of the first PET film layer 1012, the thickness of the second PET film layer 1032 and the thickness of the third PET film layer 1034 is less than or equal to 150 microns, and the sum of the thickness of the first bonding layer 1013, the thickness of the second bonding layer 1031, the thickness of the first sealing layer 105 and the thickness of the second sealing layer 106 is less than or equal to 200 microns.

In this manner, the total thickness of the PET substrates of the flexible photovoltaic module 10 is relatively small, which is conducive to achieving bending and rolling up of the flexible photovoltaic module 10 with a smaller radius of curvature. The total thickness of the first bonding layer 1013, the second bonding layer 1031, the first sealing layer 105 and the second sealing layer 106 is relatively small, so that these layers are relatively easy to bend, thus the flexibility of the flexible photovoltaic module 10 is further improved, and the flexible photovoltaic module 10 is easy to rolled up. Moreover, the metal layer 1033 having excellent water resistance performance is disposed, which can further avoid damage to the solar cells 102 caused by moisture in the air. The thickness of the metal layer 1033 is also relatively small, so that the overall thickness of the flexible photovoltaic module 10 is relatively small, and thus the flexible photovoltaic module 10 is easier to bend and roll up. The overall thickness of the flexible photovoltaic module 10 is relatively small, so that when the solar cells 102 are bent or rolled up, the tensile stress or compressive stress of the solar cells 102 is relatively small, and thus the solar cells 102 are not easy to peel off. Therefore, only bonding layers and sealing layers with smaller thicknesses are required to achieve reliable bonding. In this manner, the reliability of bonding is ensured while the flexibility of the flexible photovoltaic module 10 is improved.

An embodiment of the present application further provides a photovoltaic awning. FIG. 5 is a structural view of a photovoltaic awning according to an embodiment of the present application. As shown in FIG. 5, the photovoltaic awning includes a reel 20, a bracket 30 and the flexible photovoltaic module 10 provided in any of the preceding implementation solutions.

The bracket 30 may be mounted on a fixed surface. The bracket 30 includes a retractable support arm structure, and an end portion of the support arm is connected to the reel 20. At least part of the flexible photovoltaic module 10 is rolled up on a surface of the reel 20. The support arm can be driven mechanically or electrically, causing the reel 20 to reciprocate in a region between a first position close to the fixed surface and a second position away from the fixed surface. When the reel 20 moves towards the first position close to the fixed surface, the reel 20 can roll to roll up the flexible photovoltaic module 10 on the surface of the reel 20 to complete the operation of retracting the flexible photovoltaic module 10; when the reel 20 moves towards the second position away from the fixed surface, the reel 20 can roll to continuously release the flexible photovoltaic module 10 from the surface of the reel 20 to complete the operation of unrolling the flexible photovoltaic module 10. In the embodiment, the flexible photovoltaic module 10 may be the flexible photovoltaic module disclosed in the embodiments of the present application. The system voltage of the flexible photovoltaic module 10 applied to the photovoltaic awning in the embodiment is less than or equal to 300V Optionally, the system voltage of the flexible photovoltaic module 10 is less than or equal to 100V Optionally, the system voltage of the flexible photovoltaic module 10 is 48 V.

In another implementation, FIG. 6 is a structural view of another photovoltaic awning according to an embodiment of the present application. As shown in FIG. 6, the photovoltaic awning includes reels 20, brackets 30 and the flexible photovoltaic module 10 provided in any of the preceding implementation solutions.

A bracket 30 includes a bendable support arm structure, and two ends of the support arm are connected to the two reels 20. At least part of the flexible photovoltaic module 10 is rolled up on a surface of a reel 20; one reel 20 of the reels 20 can only rotate and cannot move, that is, the position of the one reel 20 is fixed, while the other reel 20 of the reels 20 can move. The support arm can be driven mechanically or electrically. The distance between the two reels 20 can be controlled by controlling the bending degree of the support arm of the bracket 30, thus the area of the extended flexible photovoltaic module 10 can be controlled. As the bending degree of the support arm of the bracket 30 gradually decreases, that is, as the support arm gradually extends, the support arm drives the movable reel 20 to move forward, continuously releasing the flexible photovoltaic module 10 from the surface of the position-fixed reel 20 to complete the operation of unrolling the flexible photovoltaic module 10. As the bending degree of the support arm of the bracket 30 gradually increases, the support arm drives the movable reel 20 to move, and the position-fixed reel 20 rotates to roll up the flexible photovoltaic module 10 on the surface of the position-fixed reel 20 to complete the operation of retracting the flexible photovoltaic module 10.

The technical solution of the embodiment of the present application further provides a photovoltaic power generation system. The photovoltaic power generation system includes the flexible photovoltaic module provided in any of the preceding embodiments. The photovoltaic power generation system, for example, includes at least one flexible photovoltaic module 10. The number of flexible photovoltaic modules 10 may be determined according to the power supply requirements of the electrical device and output electrical parameters (such as the output power, the output voltage or the output current) of a flexible photovoltaic module 10. The shape of the photovoltaic power generation system may be determined according to the mounting position. The shape of the photovoltaic power generation system may be determined according to the mounting position, so that the photovoltaic power generation system is applicable to different application scenarios, and thus the applicability of the photovoltaic power generation system can be improved.

The flexible photovoltaic module 10 may be in an extended state or a retracted state when applied to a photovoltaic awning, so that the photovoltaic awning can use solar cells for power generation whether the photovoltaic awning is extended or retracted. The photovoltaic awning in the extended state and the photovoltaic awning in the retracted state are used as examples for illustrating the process of power generation by solar cells.

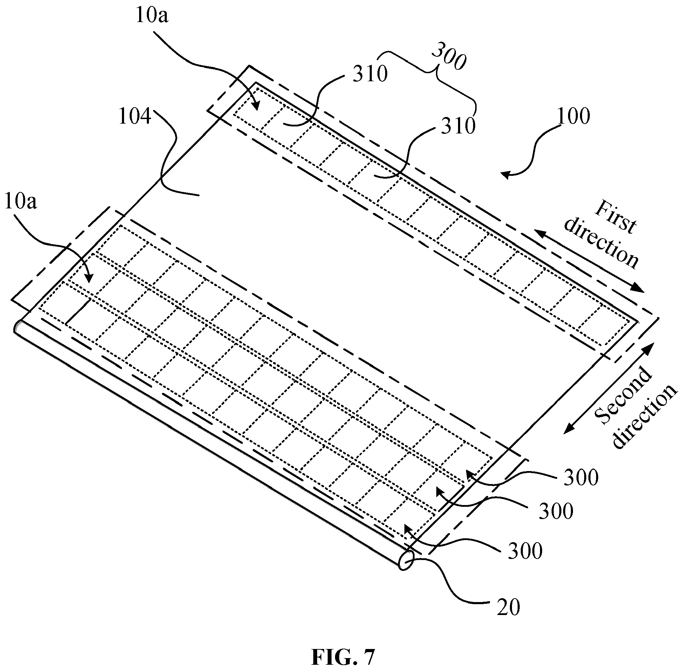

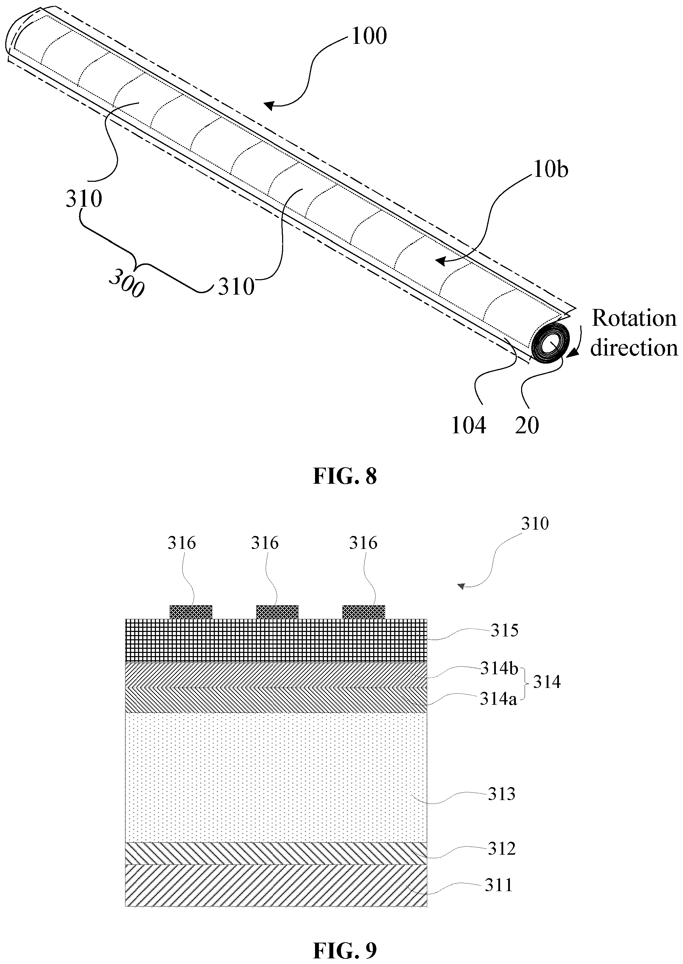

FIG. 7 illustrates a structural view of a photovoltaic awning 100 in an extended state according to an embodiment of the present application, and FIG. 8 illustrates a structural view of the photovoltaic awning 100 in a retracted state according to an embodiment of the present application. Referring to FIG. 7 and FIG. 8, the photovoltaic awning 100 includes a reel 20 and a flexible photovoltaic module including at least a fabric layer 104 and multiple flexible solar cells 310. The fabric layer 104 is able to be rolled up on the reel 20, and the fabric layer 104 may be in the extended state or the retracted state. The flexible solar cells 310 are disposed on at least one surface of the fabric layer 104.

The photovoltaic awning 100, hereinafter referred to as the awning 100, may be mounted on walls of buildings, side walls of recreational vehicles or other mounting surfaces to provide effects of shading and power generation.

The flexible solar cell 310 is made of flexible materials, so that the flexible solar cell can be bent. The awning 100 can be bent and rolled up with a smaller radius of curvature precisely due to the flexibility of the flexible solar cell 310. For example, the awning 100 can be rolled up on a reel 20 with the diameter less than 4 inches, and after being fully retracted, the awning 100 can be rolled into a cylindrical structure with the diameter of 2 inches to 12 inches, so that the space occupied by the awning 100 is greatly reduced, and the awning 100 is aesthetically acceptable to users. To further improve the flexibility of the awning 100 so that the awning can be bent and rolled up with a smaller radius of curvature, the fabric layer 104 may be inorganic fiber fabric or organic fiber fabric, where the inorganic fibers are glass fibers, quartz glass fibers, boron fibers or ceramic fibers, and the organic fibers are polyester fibers, acrylic fibers, nylon fibers or polypropylene fibers.

Referring to FIG. 9, the flexible solar cell 301 includes a conductive substrate 311, a back electrode layer 312, a photoelectric conversion layer 313, a buffer layer 314, a transparent conductive layer 315 and extraction electrodes 316 which are sequentially laminated.

The conductive substrate 311 may be stainless steel foil, titanium foil, copper foil, aluminum foil or beryllium foil, or a polymer film with an outer surface covered with a conductive oxide or a metal layer, such as a polyimide film. The back electrode layer 312 may be composed of metal conductive materials such as Ti, Ni, Cr, Ag, Al, Cu, Au, Mo, ITO, ZnO and SnO. The photoelectric conversion layer 313 includes at least four elements, that is, Cu, In, G and Se. The atomic percent of Cu is 10% to 30%, the atomic percent of In and the atomic percent of Ga is 1% to 20%, and the atomic percent of Se is 20% to 60%. The buffer layer 314 can exhibit n-type conductivity and form a PN junction with the photoelectric conversion layer 313. To improve the conductivity of the PN junction between the buffer layer 314 and the photoelectric conversion layer 313, the buffer layer 314 may be a multi-layer structure. For example, as shown in FIG. 9, the buffer layer 314 may include a CdS buffer layer 314a with the thickness of 50nm and a ZnO buffer layer 314b with the thickness of 50nm. The transparent conductive layer 315 includes one or more transparent conductive oxides (TCO), such as zinc oxide, aluminum-doped zinc oxide (AZO), indium tin oxide (ITO) and gallium-doped zinc oxide, with the thickness preferably ranging from 100nm to 2000nm to ensure transparency and conductivity. A material of the extraction electrodes 316 is the same as a material of the conductive substrate 311, and the extraction electrodes 316 may be arranged in an array to be formed on the transparent conductive layer 315.

Referring to FIG. 7, when the fabric layer 104 is in the extended state, flexible solar cells 310 have a first photoelectric conversion region 10a exposed to the external environment; referring to FIG. 8, when the fabric layer 104 is in the retracted state, flexible solar cells 310 have a second photoelectric conversion region 10b exposed to the external environment. The area of the first photoelectric conversion region 10a is larger than the area of the second photoelectric conversion region 10b. The first photoelectric conversion region 10a is the region on the awning 100 where photoelectric conversion layers of all flexible solar cells 310 within the dotted line frame in FIG. 7 are located; the second photoelectric conversion region 10b is the region on the awning 100 where photoelectric conversion layers of all flexible solar cells within the dotted line frame in FIG. 8 are located.

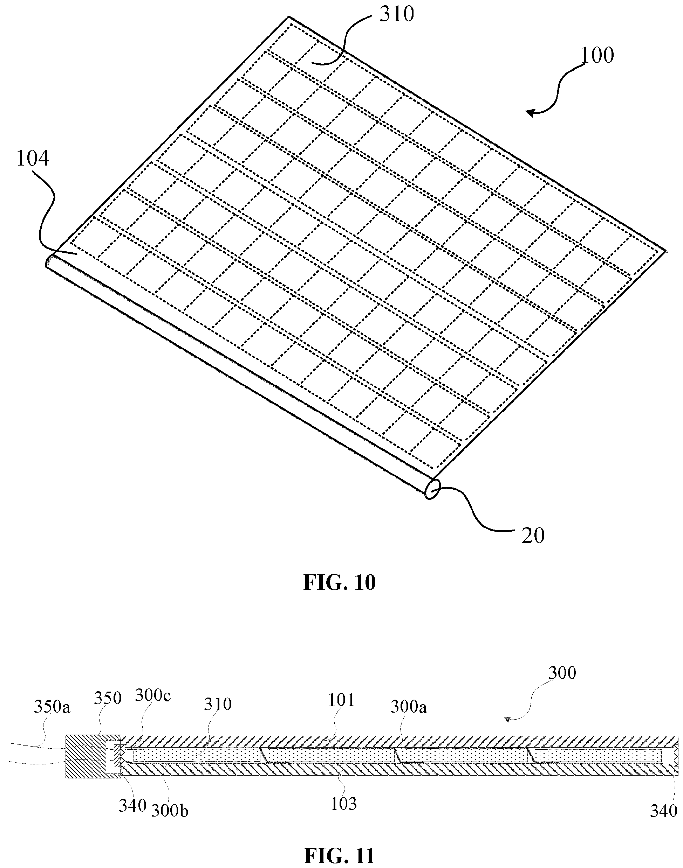

When the fabric layer 104 is extended, as shown in FIG. 7, part of the surface of the fabric layer 104 may be laid with solar cells 310; or as shown in FIG. 10, the entire surface of the fabric layer 104 may be laid with flexible solar cells 310 so that the power generation capacity of the awning 100 is improved.

When the fabric layer 104 of the awning 100 is extended through the reel 20, the first photoelectric conversion region 10a of the flexible solar cells 310 can be exposed to the external environment and illuminated by sunlight, and then the first photoelectric conversion region 10a can convert the received sunlight into electricity to achieve power generation; when the fabric layer 104 of the awning 100 is retracted through the reel 20, the second photoelectric conversion region 10b of the flexible solar cells 310 can be exposed to the external environment and illuminated by sunlight, and then the second photoelectric conversion region 10b can convert the received sunlight into electricity to achieve power generation. The awning 100 has a first photoelectric conversion region 10a for generating electricity when the awning 100 is extended and a second photoelectric conversion region 10b for generating electricity when the awning 100 is retracted, so that the awning 100 can generate electricity whether the awning 100 is extended or retracted. Especially, when the recreational vehicle is on the move, although the awning 100 is in the retracted state, the awning 100 can still generate electricity effectively by the second photoelectric conversion region 10b, so that the power generation capacity of the awning 100 is further improved.

The first photoelectric conversion region 10a and the second photoelectric conversion region 10b are located on the same surface of the fabric layer 104, for example, both on an upper surface of the fabric layer 104 when the fabric layer 104 is horizontally extended, where the first photoelectric conversion region 10a includes the second photoelectric conversion region 10b. When the fabric layer 104 is extended, the second photoelectric conversion region 10b is part of the first photoelectric conversion region 10a and can also be illuminated by sunlight for power generation, so that the second photoelectric conversion region 10b can generate electricity whether the fabric layer 104 is in the extended state or in the retracted state, and thus the utilization efficiency of the flexible solar cell 310 can be improved.

It is to be noted that to ensure that the second photoelectric conversion region 10b can be exposed to the external environment when the fabric layer 104 is in the retracted state, the reel 20 may be driven to rotate in the rotation direction shown in FIG. 8 so that the fabric can be retracted.

In some other implementations, the first photoelectric conversion region 10a and the second photoelectric conversion region 10b are located on different surfaces of the fabric layer 104. It is to be noted that to ensure that the second photoelectric conversion region 10b can be exposed to the external environment when the fabric layer 104 is in the retracted state, the reel 20 may be driven to rotate in the direction opposite to the rotation direction shown in FIG. 8 so that the fabric layer 104 can be retracted.

Flexible solar cells 310 are usually arranged on the awning 100 in the form of solar cell modules 300. An encapsulation material required for solar cell modules 300 affects the flexibility of the solar cell modules 300, and the encapsulation thickness is related to the designed service life and the rated voltage of the awning 100. That is, the longer the designed service life and the higher the rated voltage of the awning 100, the thicker the encapsulation material. In this regard, to ensure that the awning 100 can have sufficient flexibility and thus can be rolled up on a small-diameter reel 20, the present application is designed for new-type solar energy products with the service life of 1 year to 15 years and the rated voltage less than 300V, not for conventional solar energy products with the service life longer than 25 years and the rated voltage higher than 600V, and meets the requirements of International Electrotechnical Commission Technical Specification 63163 (IEC TS 63163).

Referring to FIG. 7 and FIG. 8, flexible solar cells 310 are arranged on at least one surface of the fabric layer 104 along a first direction and a second direction perpendicular to the first direction. In the first direction, adjacent solar cells are connected in series with each other to form at least one solar cell module 300, and in the second direction, adjacent solar cell modules 300 are connected in parallel with each other. The first direction is the axial direction of the reel 20, and the second direction is the direction in which the fabric layer 104 is extended or retracted. When the fabric layer 104 is not fully extended or fully retracted, solar cell modules 300 exposed to the external environment will not be affected by the rolled-up solar cell modules 300 and can generate electricity normally.

It is to be noted that when the fabric layer 104 is in the retracted state, at least one solar cell module 300 is completely or partially exposed to the external environment to form the second photoelectric conversion region 10b. That is, when the fabric layer 104 is in the retracted state, at least one complete solar cell module 300 in the second photoelectric conversion region 10b is exposed to the external environment to ensure that the second photoelectric conversion region 10b of the flexible solar cells 310 can generate electricity normally.

The number of rows of solar cell modules 300 in the second direction may be set according to the solar energy coverage requirements and the size of the awning 100. Exemplarily, when solar cell modules 300 are arranged on the same surface of the fabric layer 104, the number of rows of solar cell modules 300 in the second direction may be greater than or equal to 2 and less than or equal to 6.

Two adjacent rows of solar cell modules 300 in the second direction are aligned to accommodate the size and electrical requirements of the awning 100. In the second direction, each row of solar cell modules 300 may include one or more solar cell modules 300.

Referring to FIG. 11, flexible solar cells 310 may be encapsulated with the back sheet 103, the front sheet 101 and an edge seal 340 into a solar cell module 300. The back sheet 330 may be laminated onto the surface of the fabric layer 104 through a non-adhesive lamination or adhesive lamination manner, so that flexible solar cells 310 can also be part of the awning 100.

The edge seal 340 may be made of one or more organic or inorganic materials with a low inherent water vapor transmission rate.

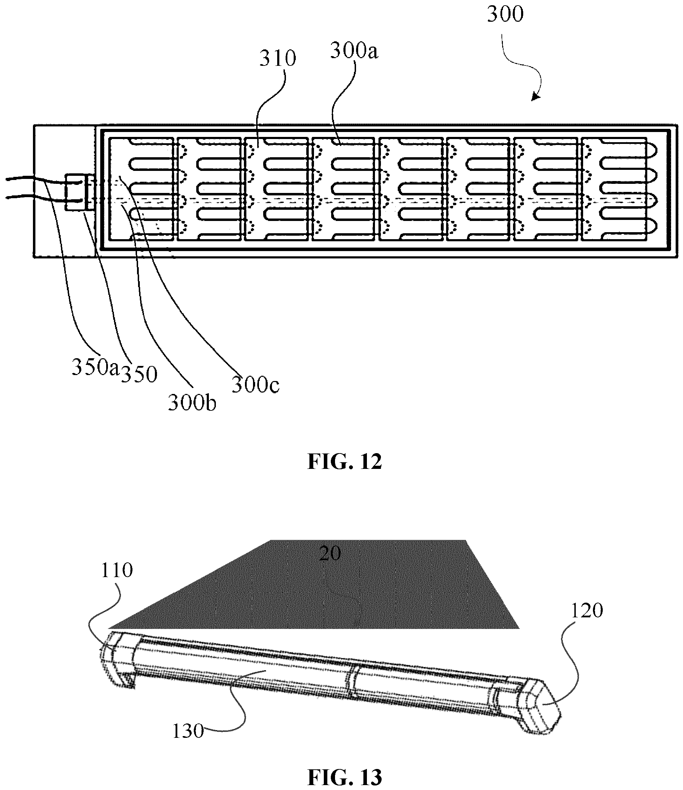

Referring to FIG. 11 and FIG. 12, the solar cell module 300 may further include an external electrical connector 350. Flexible solar cells 310 inside the solar cell module 300 are connected in series and then connected to the external electrical connector, and the current generated by the solar cell module 300 can be transmitted to an external element, such as other solar cell modules 300, inverters or the power grid, of the solar cell module 300 through a lead 350a on the external connector 350.

In the same solar cell module 300, adjacent flexible solar cells 310 are connected in series through at least one wire. Flexible solar cells 310 are connected in series through wires, so that the structure of the solar cell module 300 can be simplified, and the connection between adjacent flexible solar cells 310 is facilitated.

Referring to FIG. 11 and FIG. 12, the front of a flexible solar cell 310 is connected in series to the back of an adjacent flexible solar cell 310 in the same solar cell module 300 through a wire 300a. The front of the flexible solar cell 310 is a surface of the layer of the extraction electrodes 316 away from the transparent conductive layer 315 shown in FIG. 9, and the back of the flexible solar cell 310 is a surface of the conductive substrate 311 away from the back electrode layer 312 shown in FIG. 9.

Referring to FIG. 11 and FIG. 12, a first busbar 300b and a second busbar 300c are further disposed in the solar cell module 300. The first busbar 300b and the second busbar 300c are both connected to the external connector 350. The first busbar 300b is connected to the back of all flexible solar cells 310 except flexible solar cells 310 connected at the head and tail. The second busbar 300c is connected to the front of the flexible solar cells 310 at the head and tail. The first busbar 300b and the second busbar 300c may be solid metal strips or staggered metal strands.

Each solar cell module 300 on the fabric layer 104 may be separately connected in series to a photovoltaic power optimizer, which can solve the problem of reduced generated electricity caused by shadows, orientation differences or inconsistent attenuation of solar cell modules 300, and achieve maximum power output and online monitoring of solar cell modules 300.

Referring to FIG. 13, the reel 20 includes a first end cover 110, a second end cover 120, an outer tube 130 and a rotating shaft (not shown in the figure). The first end cover 110 and the second end cover 120 are disposed on two axial end portions of the reel 20 respectively. The rotating shaft has a first end and a second end opposite to the first end. The first end of the rotating shaft is rotatably disposed inside the first end cover 110, and the second end of the rotating shaft is rotatably disposed inside the second end cover 120. The outer tube 130 is sleeved on the outside of the rotating shaft and connected to an end portion of the fabric layer 104. When the rotating shaft rotates, the rotating shaft can drive the outer tube 130 to rotate, thereby achieving retraction and unrolling of the fabric layer 104.

The reel 20 further includes a drive assembly (not shown in the figure) disposed inside the first end cover 110. The drive assembly may include a drive wheel and a motor. The drive wheel is connected to an output shaft of the motor, and the drive wheel is disposed inside the rotating shaft. The drive wheel may be assembled inside the rotating shaft by means of a clamping groove mating with a snap. The flexible solar cells 310 on the fabric layer 104 or other adapted power sources supply power to the motor.

The reel 20 further includes a torsion spring (not shown in the figure). The torsion spring includes a first end portion and a second end portion opposite to the first end portion. The first end portion of the torsion spring is disposed inside the rotating shaft, and the second end portion of the torsion spring is disposed inside the first end cover. The torsion spring is configured to provide a force for rolling up the fabric layer 104 to the rotating shaft.

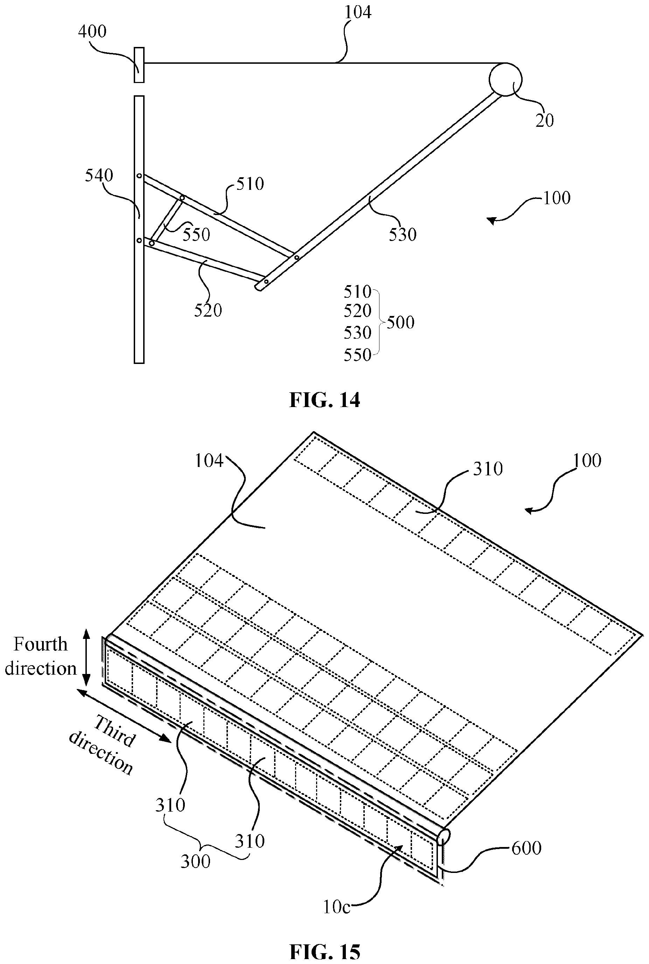

FIG. 14 illustrates a structural view of another photovoltaic awning 100 taken from a side viewpoint according to the present application. The awning 100 further includes a fixing bracket 400 and a retractable bracket 500. The fixing bracket 400 is configured to fix the awning 100 on a mounting surface, and the retractable bracket 500 is configured to unroll or retract the fabric layer 104. The fabric layer 104 includes a first end portion and a second end portion opposite to the first end portion. The first end portion of the fabric layer 104 is connected to the fixing bracket 400, and the second end portion of the fabric layer 104 is connected to the reel 20. During the extension process of the retractable bracket 500, the fabric layer 104 can be extended under the rotation of the reel 20; during the retraction process of the retractable bracket 500, the fabric layer 104 can be retracted under the rotation of the reel 20. In some other implementations, the first end portion of the fabric layer 104 is connected to the reel 20, and the second end portion of the fabric layer 104 is connected to the retractable bracket 500.

Two retractable brackets 500 may be provided. One retractable bracket 500 is connected to the first end cover of the reel 20, and the other retractable bracket 500 is connected to the second end cover of the reel 20.

The retractable bracket 500 may be a linkage structure, and the extension or retraction of the retractable bracket 500 can be achieved through hinging between connecting rods. FIG. 14 shows a non-intersecting linkage structure, and FIG. 5 shows an intersecting linkage structure. Referring to FIG. 14, the non-intersecting linkage structure may include a first connecting rod 510, a second connecting rod 520 and a third connecting rod 530. The first connecting rod 510 and the second connecting rod 520 are located in the same plane, and the first connecting rod 510, the second connecting rod 520 and the third connecting rod 530 all include a first end portion and a second end portion opposite to the first end portion. The first end portion of the first connecting rod 510 and the first end portion of the second connecting rod 520 are hinged with the mounting surface through a mounting bracket 540. The second end portion of the first connecting rod 510 and the second end portion of the second connecting rod 520 are hinged with the first end portion of the third connecting rod 530. The second end portion of the third connecting rod 530 is connected to the first end cover 110 and the second end cover 120 of the reel 20. Optionally, the non-intersecting linkage structure may further include a reinforcing rod 550, and the reinforcing rod 550 is connected to the first connecting rod 510 and the second connecting rod 520.

The retractable bracket 500 may also be a telescopic rod structure. The telescopic rod structure may include a first telescopic rod distributed horizontally and a second telescopic rod distributed obliquely. The first telescopic rod and the second telescopic rod both include a first end portion and a second end portion opposite to the first end portion. The first end portion of the first telescopic rod and the first end portion of the second telescopic rod are both fixed on the mounting surface, and the second end portion of the first telescopic rod and the second end portion of the second telescopic rod are both fixed on the reel 20. The first telescopic rod and the second telescopic rod are both formed by multiple sequentially-nested pipe fittings. A pipe fitting is extended from or retracted into an adjacent pipe fitting so that the extension and retraction of the first telescopic rod or the second telescopic rod are achieved.

On the basis of the awning shown in FIG. 7, FIG. 15 illustrates the structure of another photovoltaic awning 100 of the present application. Referring to FIG. 15, the awning 100 further includes a decorative curtain 600. The decorative curtain 600 is disposed along the axial direction of the reel 20 and is connected to the first end portion and the second end portion of the reel 20. The decorative curtain 600 plays a decoration role. In some other embodiments, the decorative curtain 600 may also be fixed on the retractable bracket 500 or the second end portion of the fabric layer 104.

Referring to FIG. 15, at least one flexible solar cell 310 is further disposed on the surface layer of the decorative curtain 600, and in a case where the fabric layer 104 is in the extended state and the retracted state, the at least one flexible solar cell 310 in the decorative curtain 600 further has a third photoelectric conversion region 10c exposed to the external environment. Regardless of whether the awning 100 is extended or retracted, the decorative curtain 600 is always exposed to the external environment, and thus flexible solar cells 310 on the decorative curtain 600 can be illuminated sunlight and then generate electricity. The third photoelectric conversion region 10c is the region on the decorative curtain 600 where photoelectric conversion layers of all flexible solar cells 310 within the dotted line frame in FIG. 15 are located.

In some other implementations, when the fabric layer 104 is retracted, the decorative curtain 600 can also be rolled up through the reel 20, and flexible solar cells 310 on the decorative curtain 600 do not generate electricity at this time.

Referring to FIG. 15, flexible solar cells 310 are also arranged in the third photoelectric conversion region 10c along a third direction and a fourth direction perpendicular to the third direction, in the third direction, adjacent solar cells 310 are connected in series with each other to form at least one solar cell module 300, and in the fourth direction, adjacent solar cell modules 300 of the at least one solar cell module 300 are connected in parallel with each other. When the decorative curtain 600 is partially blocked, blocked solar cell modules 300 do not generate electricity, while unblocked solar cell modules 300 can generate electricity normally. The third direction may be parallel to the first direction, while the fourth direction is the vertical direction.

The structure of the solar cell module 300 on the decorative curtain 600 and the connection manner of internal flexible solar cells 310 of the solar cell module 300 may be the same as the solar cell module 300 on the fabric layer 104, and will not be repeated here.

Solar cell modules 300 on the fabric layer 104 may also be connected in series to a photovoltaic power optimizer.

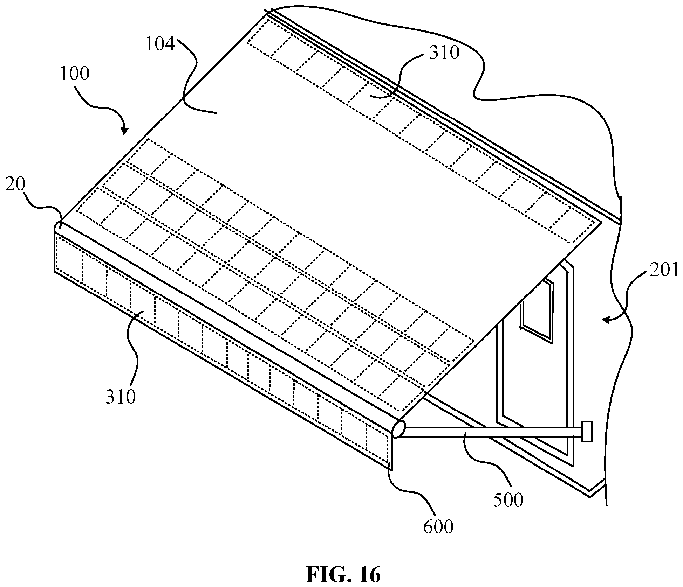

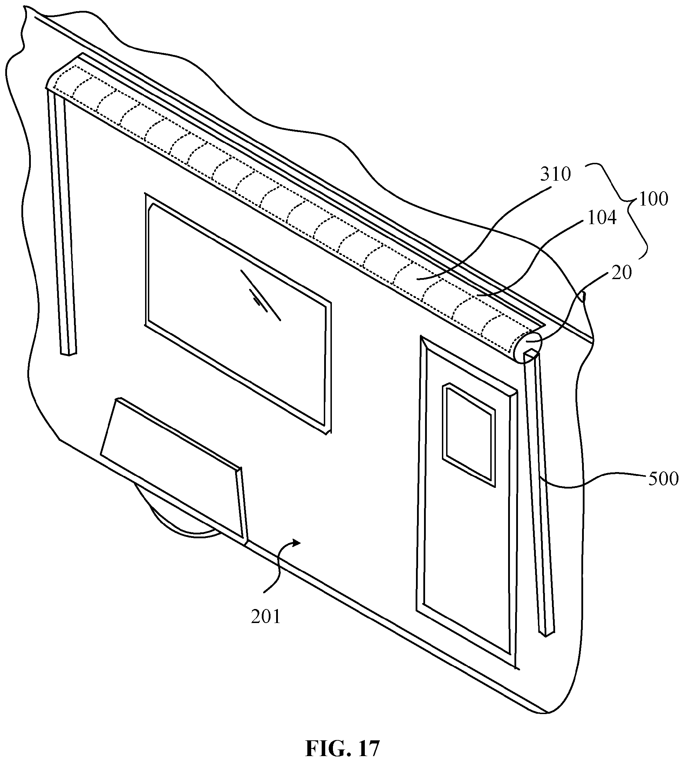

FIG. 16 illustrates a structural view of a recreational vehicle with an extended photovoltaic awning 100 according to another embodiment of the present application. FIG. 17 illustrates a structural view of a recreational vehicle with a retracted photovoltaic awning 100 according to another embodiment of the present application. Referring to FIG. 16 and FIG. 17, the recreational vehicle includes a vehicle body 201 and an awning 100 integrated with flexible solar cells 310 described above. The awning 100 is configured to be fixed on a vertical side wall of the vehicle body 201.

The recreational vehicle is also equipped with an energy storage device and an electrical device. The energy storage device is configured to be connected to the flexible solar cells 310 of the awning 100, and the electrical device is configured to be connected to the energy storage device. The electrical device may be a lighting device, such as a mood lamp suspended on the awning 100, and the electrical device may also be a display device.

Another embodiment of the present application further provides a preparation method of an awning 100 integrated with flexible solar cells 310. The preparation method includes steps described below.

In step S100, a fabric layer 104 and multiple flexible solar cells 310 are provided, and the flexible solar cells 310 are disposed on at least one surface of the fabric layer 104.

The step may include the content described below. The multiple flexible solar cells 310 are divided into multiple groups, and flexible solar cells 310 in each group are connected in series and form a solar cell module 300 through sealed encapsulation with a back sheet 330 and a front sheet 320; then, solar cell modules 300 are arranged on the fabric layer 104 along a first direction and a second direction perpendicular to the first direction, and back sheets 330 of the solar cell modules 300 are laminated on the fabric layer 104 by heating fusion.

In step S200, a reel 20 is provided, and the fabric layer 104 is rolled up on the reel 20, so that the fabric layer 104 can be in an extended state or a retracted state. When the fabric layer 104 is in the extended state, flexible solar cells 310 have a first photoelectric conversion region 10a exposed to the external environment; when the fabric layer 104 is in the retracted state, flexible solar cells 311 have a second photoelectric conversion region 10b exposed to the external environment. The area of the first photoelectric conversion region 10a is larger than the area of the second photoelectric conversion region 10b.

Multiple technical features of the preceding embodiments may be combined in any manner. For brevity of description, all possible combinations of the multiple technical features in the preceding embodiments are not described. However, as long as the combinations of these technical features do not conflict, such combinations are to be construed as being within the scope of the specification.

## Claims

1. A flexible photovoltaic module applied to a photovoltaic power generation system with a system voltage less than or equal to 300V, comprising a front sheet, a plurality of solar cells and a back sheet which are laminated, wherein the plurality of solar cells are located between the front sheet and the back sheet;
wherein the front sheet comprises a polymer film, a first PET film layer and a first bonding layer which are laminated; the first bonding layer is disposed on a first surface of the plurality of solar cells, and the first PET film layer is bonded to the plurality of solar cells through the first bonding layer;
the back sheet comprises a second bonding layer and a second PET film layer which are laminated; the second bonding layer is disposed between a second surface of the plurality of solar cells and the second PET film layer, and the second bonding layer is configured to bond the second PET film layer to the plurality of solar cells;
wherein a sum of a thickness of the first PET film layer and a thickness of the second PET film layer is less than or equal to 150 microns; and a sum of a thickness of the first bonding layer and a thickness of the second bonding layer is less than or equal to 200 microns.

2. The flexible photovoltaic module according to claim 1, further comprising a fabric layer, wherein
the fabric layer is located on a side of the back sheet facing away from the plurality of solar cells, and the fabric layer is bonded to the back sheet; an electrical insulation coating is disposed on a surface of the fabric layer facing away from the back sheet; a material of the fabric layer comprises inorganic fibers or organic fibers.

3. The flexible photovoltaic module according to claim 1 or 2, further comprising a first sealing layer and a second sealing layer, wherein
the first sealing layer is located between the plurality of solar cells and the front sheet, and the second sealing layer is located between the plurality of solar cells and the back sheet; and
a melting point of the first sealing layer and the second sealing layer is higher than 100°C; a material of the first sealing layer and the second sealing layer comprises at least one of polyvinyl butyral, polyolefin, ethylene vinyl acetate copolymer, fluorine resin, silicone resin or acrylic resin;
a sum of the thickness of the first bonding layer, the thickness of the second bonding layer, a thickness of the first sealing layer and a thickness of the second sealing layer is less than or equal to 200 microns.

4. The flexible photovoltaic module according to any one of claims 1 to 3, wherein the back sheet further comprises a meal layer and a third PET film layer; the metal layer is located on a surface of the second PET film layer facing away from the plurality of solar cells; the third PET film layer is located on a surface of the metal layer facing away from the second PET film layer; and
a sum of the thickness of the first PET film layer, the thickness of the second PET film layer and a thickness of the third PET film layer is less than or equal to 150 microns.

5. The flexible photovoltaic module according to claim 2, wherein the flexible photovoltaic module is configured to be rolled up on a reel, and the flexible photovoltaic module is capable of being in an extended state or a retracted state; and
in a case where the flexible photovoltaic module is in the extended state, the plurality of solar cells have a first photoelectric conversion region exposed to an external environment;
in a case where the flexible photovoltaic module is in the retracted state, the plurality of solar cells have a second photoelectric conversion region exposed to an external environment;
wherein an area of the first photoelectric conversion region is larger than an area of the second photoelectric conversion region;
preferably, the first photoelectric conversion region and the second photoelectric conversion region are located on a same surface of the fabric layer, and the first photoelectric conversion region comprises the second photoelectric conversion region.

6. The flexible photovoltaic module according to claim 5, wherein the plurality of solar cells are arranged along a first direction and a second direction perpendicular to the first direction;
in the first direction, adjacent solar cells of the plurality of solar cells are connected in series with each other to form at least one solar cell module, and in the second direction, adjacent solar cell modules of the at least one solar cell module are connected in parallel with each other;
preferably, in the case where the flexible photovoltaic module is in the retracted state, at least a solar cell module is fully or partially exposed to the external environment to form the second photoelectric conversion region.

7. A photovoltaic awning, comprising:
a reel;
a flexible photovoltaic module, wherein at least part of the flexible photovoltaic module is rolled up on a surface of the reel; and
a bracket, wherein the bracket comprises at least a fixing bracket and a retractable bracket, the fixing bracket is configured to fix the photovoltaic awning on a mounting surface, and the retractable bracket is configured to drive the reel to move to make the flexible photovoltaic module in an extended state or a retracted state;
wherein the flexible photovoltaic module comprises a front sheet, a plurality of solar cells and a back sheet which are laminated, and the plurality of solar cells are located between the front sheet and the back sheet;
the front sheet comprises a polymer film, a first polyethylene terephthalate, PET, film layer and a first bonding layer which are laminated; the first bonding layer is disposed on a first surface of the plurality of solar cells, and the first PET film layer is bonded to the plurality of solar cells through the first bonding layer;
the back sheet comprises a second bonding layer and a second PET film layer which are laminated; the second bonding layer is disposed between a second surface of the plurality of solar cells and the second PET film layer, and the second bonding layer is configured to bond the second PET film layer to the plurality of solar cells; and
a sum of a thickness of the first PET film layer and a thickness of the second PET film layer is less than or equal to 150 microns; a sum of a thickness of the first bonding layer and a thickness of the second bonding layer is less than or equal to 200 microns.

8. The photovoltaic awning according to claim 7, further comprising a first sealing layer and a second sealing layer,
wherein the first sealing layer is located between the plurality of solar cells and the front sheet, and the second sealing layer is located between the plurality of solar cells and the back sheet; and
a melting point of the first sealing layer and the second sealing layer is higher than 100°C; a material of the first sealing layer and the second sealing layer comprises at least one of polyvinyl butyral, polyolefin, ethylene vinyl acetate copolymer, fluorine resin, silicone resin or acrylic resin;
a sum of the thickness of the first bonding layer, the thickness of the second bonding layer, a thickness of the first sealing layer and a thickness of the second sealing layer is less than or equal to 200 microns.

9. The photovoltaic awning according to claim 7 or 8, wherein the back sheet further comprises a meal layer and a third PET film layer; the metal layer is located on a surface of the second PET film layer facing away from the plurality of solar cells; the third PET film layer is located on a surface of the metal layer facing away from the second PET film layer; and
a sum of the thickness of the first PET film layer, the thickness of the second PET film layer and a thickness of the third PET film layer is less than or equal to 150 microns.

10. The photovoltaic awning according to any one of claims 7 to 9, further comprising a fabric layer, wherein the fabric layer is located on a side of the back sheet facing away from the plurality of solar cells, and the fabric layer is bonded to the back sheet;
the fabric layer comprises a first end portion and a second end portion opposite to the first end portion;
the first end portion of the fabric layer is connected to the fixing bracket, the second end portion of the fabric layer is connected to the reel, or the first end portion of the fabric layer is connected to the reel, and the second end portion of the fabric layer is connected to the retractable bracket.

11. The photovoltaic awning according to claim 10, wherein
in a case where the flexible photovoltaic module is in the extended state, the plurality of solar cells have a first photoelectric conversion region exposed to an external environment;
in a case where the flexible photovoltaic module is in the retracted state, the plurality of solar cells have a second photoelectric conversion region exposed to an external environment;
wherein an area of the first photoelectric conversion region is larger than an area of the second photoelectric conversion region;
preferably, the first photoelectric conversion region and the second photoelectric conversion region are located on a same surface of the fabric layer, and the first photoelectric conversion region comprises the second photoelectric conversion region.

12. The photovoltaic awning according to claim 11, wherein the plurality of solar cells are arranged along a first direction and a second direction perpendicular to the first direction;
in the first direction, adjacent solar cells of the plurality of solar cells are connected in series with each other to form at least one solar cell module, and in the second direction, adjacent solar cell modules of the at least one solar cell module are connected in parallel with each other;
preferably, in the case where the flexible photovoltaic module is in the retracted state, at least a solar cell module is fully or partially exposed to the external environment to form the second photoelectric conversion region.

13. The photovoltaic awning according to claim 12, wherein in a same solar cell module of the at least one solar cell module, adjacent solar cells are connected in series through at least one wire, and a front surface of each solar cell in the same solar cell module is connected in series with a back surface of another solar cell in the same solar cell adjacent to the each solar cell through a wire of the at least one wire.

14. The photovoltaic awning according to claim 12, wherein the awning further comprises a decorative curtain, the decorative curtain is configured to be fixed to one of the second end portion of the fabric layer, the reel or the retractable bracket; and
at least one solar cell is further configured to be disposed on a surface layer of the decorative curtain, and in a case where the flexible photovoltaic module is in the extended state or the retracted state, the at least one solar cell in the decorative curtain comprises a third photoelectric conversion region exposed to the external environment;
preferably, the at least one solar cell is arranged in the third photoelectric conversion region along a third direction and a fourth direction perpendicular to the third direction;
in the third direction, adjacent solar cells of the at least one solar cell are connected in series with each other to form at least one solar cell module in the third photoelectric conversion region, and in the fourth direction, adjacent solar cell modules of the at least one solar cell module in the decorative curtain are connected in parallel with each other.

15. A recreational vehicle, comprising a vehicle body and the photovoltaic awning according to any one of claims 7 to 14, wherein the photovoltaic awning is configured to be fixed on a vertical side wall of the vehicle body.
